# EUROPÄISCHE PATENTANMELDUNG

(11) **EP 2 717 246 A2**
(43) Veröffentlichungstag der Anmeldung: **09.04.2014**
(21) Anmeldenummer: 13173766.0
(22) Anmeldetag: 26.06.2013
(51) Int. Cl.: G09F 19/22, G09F 15/00

(54) **Werbebande für Veranstaltungsdekorationen und Verfahren zur Herstellung und Anbringung von Werbebanden**

(30) Priorität: 05.10.2012 DE 102012109472
(71) Anmelder: Bethke, Jürgen, 99085 Erfurt (DE)
(72) Erfinder: Bethke, Jürgen, 99085 Erfurt (DE); Bethke, Ina, 99084 Erfurt (DE); Bethke, Christof, 99099 Erfurt (DE)
(74) Vertreter: Liedtke, Klaus

(57) **Zusammenfassung**

Werbebande für Veranstaltungsdekorationen und Verfahren zur Herstellung und Anbringung von Werbebanden.

Die Erfindung betrifft eine Werbebande mit einer mit einer Grafik bedruckten Materialbahn und ein Verfahren zur Herstellung und Anbringung von Werbebanden.

Die Werbebande weist eine Grafik auf, die auf einer einfarbig eingefärbten textilen Stoffbahn (4) mittels Siebdruck aufgedruckt und auf einer Unterkonstruktion (1) aufgespannt ist. Bei dem Verfahren zur Herstellung und Anbringung von Werbebanden wird eine Materialbahn aus einer textilen Stoffbahn (4) verwendet, wobei die Stoffbahn (4) zunächst einfarbig eingefärbt wird, auf die eingefärbte Stoffbahn (4) eine Grafik mit einer Werbebotschaft aufgedruckt wird und die bedruckte Stoffbahn (4) auf eine Unterkonstruktion (1) gespannt wird.

## Beschreibung

Die Erfindung betrifft eine Werbebande für Veranstaltungsdekorationen mit einer mit einer Grafik bedruckten Materialbahn und ein Verfahren zur Herstellung und Anbringung von Werbebanden.

Das Verfahren ist insbesondere zur Herstellung von Werbebanden geeignet, die in Veranstaltungsstätten angebracht werden. Werbebanden werden insbesondere in Fußballstadien oder bei anderen Sportveranstaltungsorten angebracht. Dabei sind auf der Sichtseite der Banden häufig die Werbung und die Namen von Firmen und Einrichtungen angebracht. Bei bestimmten Anlässen ist es erforderlich, diese Werbung durch andere Werbebotschaften zu ersetzen. Die vorliegende Werbebande und das vorliegende Verfahren betreffen Werbebanden, die eine vorhandene Dauerwerbung ersetzen würden. Dazu ist es erforderlich, eine Werbebande anzubringen, welche die dort angebrachte Dauerwerbung zeitweilig überdeckt und nach einer gewissen Zeit wieder abgenommen werden kann. Die Werbebande kann auch an werbefreien Flächen, wie z. B. Betonmauern, Geländer, Zäune usw. angebracht werden. Dabei darf die Dauerwerbung sowie an dieser oder hinter diese sich befindende Stützelemente, wie Mauern oder Geländer, nicht beschädigt werden.

Werbebanden sind aus dem Stand der Technik in vielfältigen Ausführungen bekannt.

In DE 10 2009 009 137 B4 ist eine Werbebandeinrichtung bekannt, welche eine Rahmenkonstruktion aufweist, an der eine Platte, Bespannung oder dergleichen befestigt werden kann, wobei das Werbebandenelement mindestens einen schwenkbar angeordneten Fuß aufweist.

Ferner ist in DE 20 2008 006 975 U1 eine Werbebande beschrieben, die eine rechteckige Frontplatte aufweist, welche auf einem Ständerelement aufgestützt ist, wobei die Frontplatte durch zu ihren Längskanten parallele Abkantungen streifenförmig in mehrere ebene Flächen, nämlich eine obere Randfläche, eine Motivfläche und eine untere Randfläche, unterteilt ist.

In DE 103 34 039 A1 ist eine Werbebande beschrieben, die einen Stützrahmen mit einer konvex gekrümmten Stützauflage aufweist, über deren Außenseite ein Flachmaterial geführt ist, das auf seiner Außenseite mit Werbemotiven versehen ist. Als Flachmaterial ist eine Kunststofffolie oder eine kunststoffbeschichtete Stoffbahn vorgesehen. Aufgabe dieser Erfindung ist es, ein bestimmtes Werbemotiv so darzustellen, dass es aus einer entfernten Position hervorgehoben erkannt werden kann.

Der Erfindung liegt die Aufgabe zugrunde, eine Werbebande und ein Verfahren zur Herstellung und Anbringung von Werbebanden anzugeben, mit dem Webeträger abnehmbar angebracht werden können, wobei die Werbeträger sowohl eine dauerhafte, faltenfreie Fläche bilden sollen.

Die Aufgabe wird erfindungsgemäß mit einer Werbebande, welche die in Anspruch 1 angegebenen Merkmale aufweist und mit einem Verfahren, welches die im Anspruch 7 angegebenen Merkmale aufweist, gelöst.

Vorteilhafte Ausgestaltungen der Erfindung sind Gegenstand der Unteransprüche.

Die Werbebande ist mit einer Grafik bedruckt, wobei die Grafik auf einem einfarbig eingefärbten textilen Stoff aufgedruckt ist und wobei die Werbebande auf einer Unterkonstruktion aufgespannt und befestigt ist.

Die Grafik wird auf eine zunächst einfarbig hergestellte unbeschichtete Stoffbahn aufgedruckt. Das Werbemotiv befindet sich deshalb unmittelbar auf der unbeschichteten Stoffbahn. Durch die Vermeidung von Folien kann eine beständige faltenfreie Werbefläche realisiert werden. Eine wichtige Einsatzmöglichkeit ist die Neutralisierung von vorhandenen Werbebanden, die für bestimmte Ereignisse temporär abgedeckt und mit der auf dem Werbeträger aus Stoff aufgebrachten Werbung ersetzt werden. Hierzu wurden bisher blickdichte Folien verwendet. Da diese Folien im angebrachten Zustand glänzend sind und sich nicht straff montieren lassen, weil sich das Kunststoffmaterial bei Sonne dehnt, kann mit diesen Banden keine befriedigende dekorative Wirkung erreicht werden. Die erfindungsgemäße Lösung lässt sich nicht nur leicht in einem Stadion montieren, sondern sie kann auch gereinigt, genäht und mehrfach wieder verwendet werden. Durch die Verwendung der weichen Stoffe kann jede beliebige realisiert werden.

Die Verwendung von Stoff ist mit einer Reihe von Vorteilen verbunden. Hierzu gehören:
- Stoff kann gut verarbeitet und an die jeweiligen Gegebenheiten angepasst werden. Er kann faltenfrei gespannt und z. B. durch Umschlagen an den Rändern der Bahn an jede Situation angepasst werden,
- durch Nähen kann eine einfache Herstellung der Bahnen und deren Wiederverwendbarkeit erreicht werden,
- im Gegensatz zum Einsatz von Folien kann das Bedrucken auf eine zunächst einfarbig eingefärbte Stoffbahn durch das kostengünstige Siebdruckverfahren erfolgen,
- durch die kostengünstige Herstellung und die leichte Anpassung an jede Befestigungsgegebenheit wird die temporäre Verwendung von Werbebanden ermöglicht, wobei stationäre Werbeflächen zeitweilig abgedeckt werden können,
- die Unterkonstruktion kann einfach und kostengünstig befestigt werden,
- die Anordnung kann als schwer entflammbare Ausrüstung eingestuft werden, und
- die Unterkonstruktion kann eine Standvorrichtung enthalten oder an einer vorhandenen Befestigungsanordnung angebracht werden.

Bei dem Verfahren wird eine Werbebotschaft auf ein flexibles Material aufgebracht, wobei als flexibles Material ein textiler Stoff verwendet wird. Der Stoff wird zunächst mit an sich bekannten Verfahren mit einem bestimmten Farbton eingefärbt und erst anschließend mit einer Grafik bedruckt, welche eine Werbebotschaft übermitteln soll. Als Grafik wird beispielsweise ein Logo genutzt, das einzeln oder mehrfach aufgedruckt wird. Das Aufdrucken der Werbebotschaft auf den einfarbig gefärbten Stoff erfolgt mit einem Siebdruckverfahren. Der so bedruckte Stoff wird danach auf eine Unterkonstruktion aufgebracht, wobei der Stoff gespannt und befestigt wird. Die Unterkonstruktion kann vor Ort angefertigt werden, wobei diese an die dort bestehenden Gegebenheiten angepasst wird. Damit können beispielsweise Eingänge oder anderweitige Unterbrechungen an Stadienbanden berücksichtigt werden. Es ist auch möglich, die Unterkonstruktion an eine vorhandene Befestigungsanordnung anzubringen. Solche Befestigungsanordnungen können beispielsweise Mauern, Brüstungen oder Geländer sein.

Es wird eine werbewirksame Sichtwand mit durchgängiger Grafik ohne störenden sichtbaren Rahmen geschaffen. Vorteilhaft ist dabei, dass eine hohe Sichtqualität der Werbefläche erreicht wird, weil der als Werbeträger verwendete Stoff verspannt und somit faltenfrei auf die Unterkonstruktion aufgebracht werden kann. Es kann druckfähiges und lichtbeständiges Material verwendet werden, welches auch den erforderlichen Brandschutzbestimmungen gerecht wird. Besonders vorteilhaft ist, dass der Stoff von der Unterkonstruktion entfernt werden kann, so dass das Material mehrfach verwendet werden kann. Hierzu kann die Stoffbahn nach dem Entfernen gereinigt, in Abschnitte getrennt und entsprechend dem neuen Einsatzfall wieder zusammengenäht werden. Dabei werden die örtlichen Gegebenheiten berücksichtigt, so dass unter Einbeziehung der neuen baulichen Anordnungen, z. B. Türen, Fluchttore und dergleichen, eine neue Werbebande mit dem bereits aufgedruckten Kundenmuster entsteht.

Die Unterkonstruktion wird üblicherweise aus Holz angefertigt, kann aber auch aus Kunststoff oder aus Aluminium-Verbundplatten bestehen.

Für das Befestigen des bedruckten Stoffs an der Unterkonstruktion ist Tackern besonders geeignet, weil damit in einfacher Weise beliebige Flächen befestigt werden können und der Stoff ohne Schäden wieder von der Unterkonstruktion entfernt und für weitere Anwendungen nochmals verwendet werden kann. Es ist aber auch möglich, dass die Befestigung durch Klebebänder, durch Kabelbinder oder Schellen erfolgt.

Die Unterkonstruktion kann vor Ort aufgestellt oder an eine vorhandene Befestigungsanordnung befestigt werden. Das Befestigen an einer vorhandenen Einrichtung erfolgt beispielsweise mit u-förmig gebogenen Schienen aus Stahl, Aluminium oder Aluminium-Verbundwerkstoffen. Als Befestigungsmittel können auch Holz- oder Kunststoffkonstruktionen sowie Kabelbinder oder Klebebänder verwendet werden.

Ausführungsbeispiele der Erfindung werden im Folgenden anhand von Zeichnungen näher erläutert.

Darin zeigen:
- Figur 1: schematisch den Ablauf zur Herstellung der bedruckten Stoffbahn,
- Figur 2: die Befestigung der Stoffbahn an einer Unterkonstruktion,
- Figur 3: eine Ausführungsform für eine Unterkonstruktion mit Befestigung durch ein Biegeteil,
- Figur 4: eine Ausführungsform für eine Unterkonstruktion mit Befestigung durch ein Biegeteil im montierten Zustand und
- Figur 5: eine Ausführungsform für eine Unterkonstruktion mit Befestigung durch Kabelbinder.

Einander entsprechende Teile sind in allen Figuren mit den gleichen Bezugszeichen versehen.

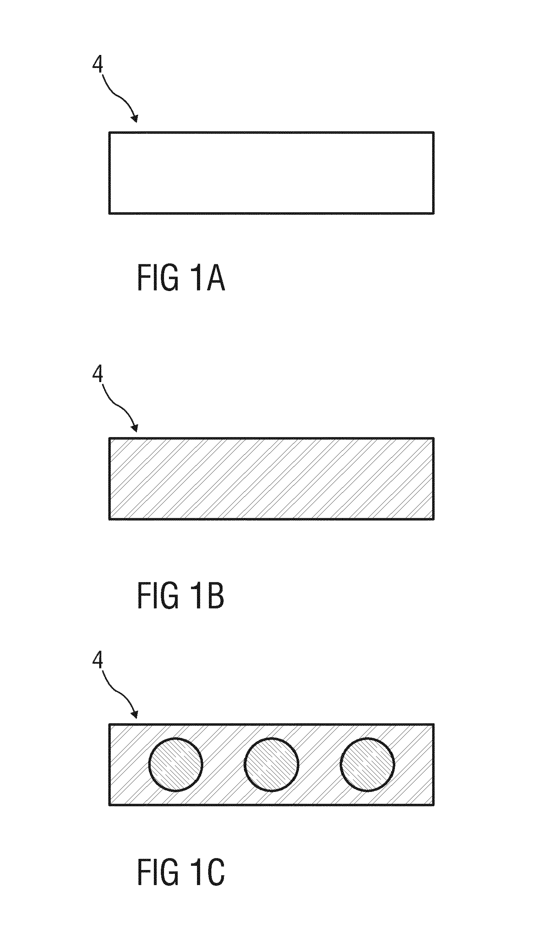

In **Figur 1** ist der Ablauf zur Herstellung der Webebande dargestellt. Gezeigt sind jeweils die Ergebnisse der einzelnen Verfahrensschritte.

Zunächst wird gemäß Figur 1a eine Stoffbahn 4 auf eine zur Bearbeitung geeignete Länge beschnitten. Anschließend wird die Stoffbahn 4 in der Farbe, die für die Werbung geeignet ist, einfarbig eingefärbt. Die einfarbig eingefärbte Stoffbahn 4 zeigt Figur 1b. Anschließend wird wenigstens eine Grafik mittels Siebdruck auf die einfarbig eingefärbte Stoffbahn 4 aufgedruckt. Als Grafik kann ein Logo, ein grafisch gestalteter Werbetext oder ein fotografisches Motiv verwendet werden.

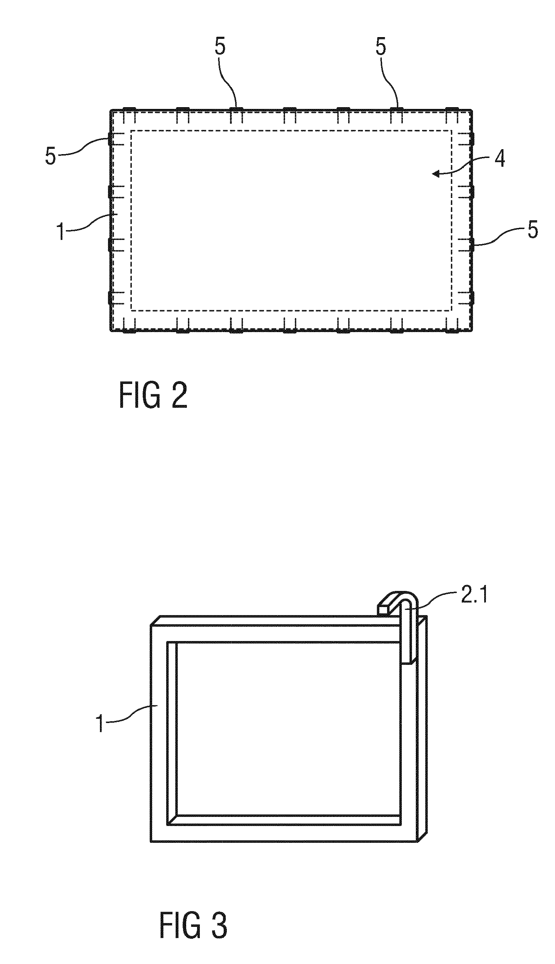

**Figur 2** erläutert die Befestigung einer Stoffbahn 4 an der Unterkonstruktion 1. Die eingefärbte und mit einer Grafik bedruckte Stoffbahn 4 wird über die Unterkonstruktion 1 gespannt und anschließend mit Tackerstiften 5 an den Stirnseiten der Unterkonstruktion 1 befestigt.

**Figur 3** zeigt eine Ausführungsform für eine Anwendung in einem Sportstadion mit einer Unterkonstruktion 1, die aus einem Holzrahmen angefertigt wurde. An der Unterkonstruktion 1 ist ein Biegeteil 2.1 befestigt, welches an einer im Stadion vorhandenen Standvorrichtung 3, die zum Beispiel aus einem Zaun bestehen kann, so befestigt wird, dass das Biegeteil 2.1 über einen oberen Rand des Zauns gebogen wird.

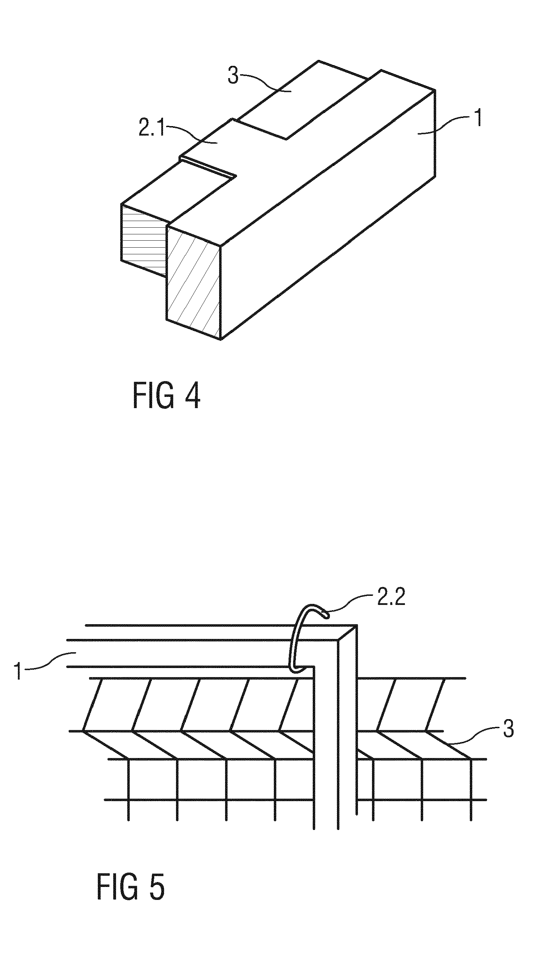

In **Figur 4** ist die Anordnung im montierten Zustand dargestellt. Das Biegeteil 2.1 ist jetzt über die obere Begrenzung einer Standvorrichtung 3 gebogen. Es ist dabei so verformt, dass die Unterkonstruktion 1 formschlüssig mit der Standvorrichtung 3 verbunden ist.

In **Figur 5** ist eine Ausführungsform dargestellt, bei der die Unterkonstruktion 1 mit Kabelbindern 2.2 an der Standvorrichtung 3 befestigt ist. Als Standvorrichtung 3 dient hierbei ein Metallzaun.

### BEZUGSZEICHENLISTE

- 1: Unterkonstruktion
- 2.1: Biegeteil
- 2.2: Kabelbinder
- 3: Standvorrichtung
- 4: Stoffbahn
- 5: Tackerstifte

## Patentansprüche

1. Werbebande mit einer mit einer Grafik bedruckten Materialbahn, die auf einer Unterkonstruktion (1) angebracht ist,
**dadurch gekennzeichnet, dass** die Grafik auf einer unbeschichteten, einfarbig eingefärbten, textilen Stoffbahn (4) aufgedruckt ist, die auf der Unterkonstruktion (1) aufgespannt und befestigt ist, wobei die Grafik mittels Siebdruck auf der einfarbig eingefärbten Stoffbahn (4) aufgebracht ist.

2. Werbebande nach Anspruch 1,
**dadurch gekennzeichnet, dass** die Unterkonstruktion (1) eine Aufstellvorrichtung enthält.

3. Werbebande nach Anspruch 1,
**dadurch gekennzeichnet, dass** die Unterkonstruktion (1) an einer vorhandenen Standvorrichtung (3) angebracht ist.

4. Werbebande nach einem der vorhergehenden Ansprüche,
**dadurch gekennzeichnet, dass** die Unterkonstruktion (1) aus Holz besteht.

5. Werbebande nach einem der vorhergehenden Ansprüche,
**dadurch gekennzeichnet, dass** die Unterkonstruktion (1) aus Kunststoff oder aus Aluminium-Verbundplatten besteht.

6. Werbebande nach einem der vorhergehenden Ansprüche,
**dadurch gekennzeichnet, dass** die bedruckte Stoffbahn (4) auf der Unterkonstruktion (1) durch Tackern befestigt ist.

7. Verfahren zur Herstellung und Anbringung von Werbebanden, bei dem eine mit einer Grafik bedruckte Materialbahn aufgestellt wird,
**dadurch gekennzeichnet, dass**
- für die Materialbahn eine textile Stoffbahn (4) verwendet wird,
- die Stoffbahn (4) zunächst einfarbig eingefärbt wird,
- auf die eingefärbte Stoffbahn (4) die Grafik mit einer Werbebotschaft aufgedruckt wird,
- wobei das Bedrucken der einfarbig eingefärbten Stoffbahn (4) mittels Siebdruck erfolgt,
- die bedruckte Stoffbahn (4) auf eine vor Ort angefertigte Unterkonstruktion (1) aufgespannt wird.

8. Verfahren nach Anspruch 7,
**dadurch gekennzeichnet, dass** die Unterkonstruktion (1) an einer vorhandene Befestigungsanordnung befestigt wird.

9. Verfahren nach Anspruch 8,
**dadurch gekennzeichnet, dass** die Unterkonstruktion (1) an der vorhandenen Befestigungsanordnung mittels gebogener Aluminiumschienen befestigt wird.
